# EUROPÄISCHE PATENTSCHRIFT

(11) **EP 2 603 806 B1**
(45) Veröffentlichungstag und Bekanntmachung des Hinweises auf die Patenterteilung: **11.07.2018**
(21) Anmeldenummer: 11746498.2
(22) Anmeldetag: 19.07.2011
(51) Int. Cl.: G01R 31/317

(54) **VERFAHREN UND VORRICHTUNG ZUM VERHINDERN VON SIGNALFLANKENVERLUSTEN**
METHOD AND DEVICE FOR PREVENTING SIGNAL EDGE LOSSES
PROCÉDÉ ET DISPOSITIF POUR ÉVITER DES PERTES DE FLANCS DE SIGNAUX

(30) Priorität: 12.08.2010 DE 102010034068
(43) Veröffentlichungstag der Anmeldung: 19.06.2013
(73) Patentinhaber: Rohde & Schwarz GmbH & Co. KG, 81671 München (DE)
(72) Erfinder: HERBORDT, Wolfgang, 80687 München (DE); KUHWALD, Thomas, 85570 Markt Schwaben (DE); NITSCH, Bernhard, 81825 München (DE); REICH, Friedrich, 86391 Stadtbergen (DE)
(74) Vertreter: Körfer, Thomas
(86) Internationale Anmeldenummer: PCT/EP2011/062297
(87) Internationale Veröffentlichungsnummer: WO 2012/019880

(56) Entgegenhaltungen:
- EP-A1- 0 123 381
- EP-A1- 1 783 505
- WO-A2-2008/051856
- JP-A- 4 138 375
- JP-A- 2008 170 246
- US-A1- 2004 078 157
- US-B1- 6 768 430

## Beschreibung

Die Erfindung betrifft ein Verfahren und eine Vorrichtung zum Verhindern von Signalflankenverlusten durch Dezimierung von binären Signalen.

Binäre Signale in einer bestimmten Abtastrate werden über eine Dezimierung mit einem bestimmten Dezimationsfaktor in dezimierte binäre Signale in einer reduzierten Abtastrate überführt. Neben der Dezimierung mit einem fixen Dezimationsfaktor ist die Dezimierung mit einem variablen Dezimationsfaktor weit verbreitet. Eine Dezimierung mit einem variablen Dezimationsfaktor geht beispielsweise aus der DE 10 2007 018 095 A1 hervor. Einschlägige Dokumente zum Stand der Technik sind ferner die JP 4 138375, EP 0 123 381, EP 1 783 505, WO 2008/051856, JP 2008 170246, US 2004/078157, und US 6 768 430. Wird ein binäres Signal und werden die zu einem Bussignal gehörigen binären Signale mit einem Dezimationsfaktor dezimiert, so können Signalflanken im dezimierten binären Signal bzw. in den zum Bussignal gehörigen dezimierten binären Signalen verschwinden. Hierbei können pro Dezimationsintervall auch mehrere Signalflanken und damit ganze Pulse oder Pulspausen verloren gehen. Dieser Signalinformationsverlust ist insbesondere bei Anwendungen, bei denen es auf eine exakte Signalanalyse ankommt, nicht hinnehmbar.

Aufgabe der Erfindung ist es deshalb, ein Verfahren und eine Vorrichtung zur Verhinderung derartiger Signalflankenverluste bei der Dezimierung binärer Signale zu schaffen.

Die Erfindungsaufgabe wird durch ein Verfahren zur Anpassung des Dezimationsfaktors in Abhängigkeit der Anzahl von Signalflanken pro Anzahl von Abtastwerten mit den Merkmalen des Anspruchs 1 und durch eine zugehörige Vorrichtung zur Anpassung des Dezimationsfaktors in Abhängigkeit der Anzahl von Signalflanken pro Anzahl von Abtastwerten mit den Merkmalen des Anspruchs 3 und durch ein Verfahren zur Anpassung eines Dezimationsfaktors in Abhängigkeit der Pulsdauer von Pulsen und Pulspausen mit den Merkmalen des Anspruchs 2 und durch eine zugehörige Vorrichtung zur Anpassung eines Dezimationsfaktors in Abhängigkeit der Pulsdauer von Pulsen und Pulspausen mit den Merkmalen des Anspruchs 4 gelöst. Vorteilhafte Weiterbildungen werden in den abhängigen Ansprüchen angegeben. Andere Ansprüche beziehen sich auf ein Computerprogramm-Produkt und einen Datenträger.

Zur Kennzeichnung von Signalflankenverlusten in dezimierten binären Signalen werden in jedem binären Signal aufeinander folgende Signalabschnitte mit einer dem Dezimationsfaktor entsprechenden Anzahl von Abtastwerten bestimmt, die den einzelnen Dezimationsintervallen entsprechen. In jedem dieser Signalabschnitte wird jeweils die Anzahl von Signalflanken vor der Dezimierung des jeweiligen binären Signals gezählt. Ist die Anzahl der im jeweiligen Signalabschnitt detektierten Signalflanken größer als eins, können diese Signalflanken auch unter Berücksichtigung der Signalpegelinformation der jeweils vorausgehenden und der jeweils nachfolgenden Signalabschnitte nach der Dezimierung nicht mehr insbesondere hinsichtlich ihrer Signalflankenrichtung exakt rekonstruiert werden und gehen deshalb für eine korrekte Signalanalyse verloren. In diesem Fall wird die Signalflanke in dem Abtastwert des jeweiligen dezimierten binären Signals, der sich auf den Signalabschnitt des zugehörigen binären Signals mit mehr als einer detektierten Signalflanke bezieht, beispielsweise durch einen besonderen Farb- oder Grauton gekennzeichnet.

Während eine Signalflanke, ein Puls oder eine Pulspause zwischen zwei aufeinander folgenden Pulsen im dezimierten binären Signal direkt u.U. nicht zu erkennen und damit detektierbar ist, wird dies beim nicht-dezimierten binären Signal vorausgesetzt. Der Abstand zweier Signalflanken, die Pulsdauer und die Pulspause zwischen zwei Pulsen in einem binären Signal müssen folglich mindestens dem Abstand zweier Abtastwerte des binären Signals entsprechen.

Signalflanken in zu einem Bussignal jeweils gehörigen binären Signalen oder in mehreren sequentiell aufeinander folgenden Signalabschnitten eines einzigen binären Signals werden auf verschiedene Art und Weise gekennzeichnet:
Analog zum Fall eines einzigen binären Signals werden in einer ersten Variante in einem binären Signal oder in mehreren binären Signalen eines Bussignals durch Dezimierung jeweils entfernte Signalflanken jeweils durch eine gesonderte Kennzeichnung der Signalflanke im Abtastzeitpunkt des jeweiligen dezimierten binären Signals signalisiert, der sich auf den Signalabschnitt des zugehörigen binären Signals mit mindestens einer durch Dezimierung entfernten Signalflanke bezieht.

In einer zweiten Variante werden die einzelnen zu einem Bussignal gehörigen binären Signale zu einem einzigen binären Signal zusammengefasst, wobei die Häufigkeit der Wertigkeit des Signalpegels - aktivierter Signalpegel oder nicht-aktivierter Signalpegel - über alle binären Signale des Bussignals zu einem bestimmten Abtastzeitpunkt als spezifischer Farb- oder Grauton oder als spezifisches Muster des/r zur Wertigkeit des Signalpegels oder zur Signalflanke und zum Abtastzeitpunkt gehörigen Bildpunkte(s) der Visualisierungseinrichtung dargestellt wird. Eine durch Dezimierung entfernte Signalflanke wird wiederum wie in der ersten Variante durch einen gesonderten Farb- oder Grauton gekennzeichnet.

Daneben wird eine durch Dezimierung in mindestens einem binären Signal des Bussignals im selben Abtastzeitpunkt entfernte Signalflanke in einer dritten Variante durch gesondert - beispielsweise durch einen speziellen Farb- oder Grauton - gekennzeichnete, eine positive und gleichzeitig eine negative Signalflanke darstellende Bildpunkte in einer zum Abtastzeitpunkt gehörigen horizontalen Position auf der Visualisierungseinheit signalisiert.

Die eine negative und eine positive Signalflanke darstellenden Bildpunkte gehen für den Fall, dass in den benachbarten Abtastzeitpunkten der dezimierten binären Signale jeweils keine entfernten Signalflanken detektiert werden, jeweils in den zu jeweils benachbarten Abtastzeitpunkten gehörigen horizontalen Positionen auf der Visualisierungseinheit in Bildpunkte über, die jeweils einen aktivierten Signalpegel und einen nichtaktivierten Signalpegel von binären Signalen des Bussignals darstellen. Die Wertigkeit der Signalpegel der einzelnen binären Signale des Bussignals wird für den Fall, dass im jeweiligen Abtastzeitpunkt der dezimierten binären Signale keine entfernte Signalflanke detektiert wird, als Binär-, Oktal- oder Hexadezimalwert oder als Wert jedes beliebig anderen Zahlensystems ausgedrückt und in der zum jeweiligen Abtastzeitpunkt gehörigen horizontalen Position auf der Visualisierungseinrichtung dargestellt.

Die als Binär-, Oktal- oder Hexadezimalwert ausgedrückte Wertigkeit der Signalpegel der einzelnen zum Bussignal gehörigen binären Signale wird alternativ in einer vierten Variante in Kombination mit dem zugehörigen Abtastzeitpunkt als Ordinaten-Abszissen-Wertepaar auf einem zum Ordinaten-Abszissen-Wertepaar gehörigen Bildpunkt der Visualisierungseinrichtung in einem bestimmten Farb- oder Grauton dargestellt. Die zu den einzelnen Ordinaten-Abszissen-Wertepaare gehörigen Bildpunkte werden durch Bildpunkte der Visualisierungseinrichtung mit dazwischenliegenden Ordinatenwerten dargestellt, die auf einer vertikalen Geraden mit einem Abszissenwert liegen, der dem höherwertigen Abszissenwert der beiden Ordinaten-Abszissen-Wertepaare entspricht.

Liegt eine entfernte Signalflanke bei einem oder mehreren Abtastzeitpunkten vor, so werden die Bildpunkte der Visualisierungseinheit auf einer vertikalen Gerade beim zum Abtastzeitpunkt gehörigen Abszissenwert in einem besonderen Farb- oder Grauton gesondert gekennzeichnet. Der oberste und unterste Bildpunkt auf der zur entfernten Signalflanke gehörigen vertikalen Gerade kennzeichnen jeweils die Grenzen des Wertebereichs des Binär-, Oktal- oder Hexadezimal-Werts, der aus der nicht eindeutigen Zuordnung des Signalpegels eines binären Signals zu einem Wert im Fall einer entfernten Signalflanke resultiert. Zur Darstellung kann jeder auf der Geraden liegende Bildpunkt oder auch nur jeder n-te auf der Geraden liegende Bildpunkt herangezogen werden. Alternativ können auch alle Bildpunkte der Bildschirmspalte, in der die entfernte Signalflanke liegt, gekennzeichnet werden.

Schließlich wird die als Binär-, Oktal- oder Hexadezimalwert ausgedrückte Wertigkeit der Signalpegel der einzelnen zum Bussignal gehörigen binären Signale zu den einzelnen Abtastzeitpunkten in einer fünften Variante jeweils als Tabellenwert auf der Visualisierungseinrichtung dargestellt. Liegt eine entfernte Signalflanke bei einem oder mehreren der binären Signale des Bussignals zu einem der Abtastzeitpunkte vor, so enthält die zugehörige Binär-, Oktal- oder Hexadezimalziffer des zum jeweiligen Abtastzeitpunkt gehörigen Binär-, Oktal- oder Hexadezimalwerts eine Sonderziffer, beispielsweise eine X, und wird optional durch farbliches Hervorheben der Sonderziffer mit einer besonderen Farbe zusätzlich gekennzeichnet.

Ein durch Dezimierung bedingter Signalflankenverlust wird verhindert, indem der Dezimationsfaktor kontinuierlich an die Signalflanken-Charakteristik des binären Signals bzw. der zum Bussignal gehörigen binären Signale angepasst wird.

Hierzu wird in einer ersten Ausführungsform von einem Detektor die Anzahl von Signalflanken in jedem einzelnen Signalabschnitt der einzelnen binären Signale gezählt. Anschließend werden von einer Steuerungseinheit der Dezimationsfaktor und damit die Anzahl von Abtastwerten in jedem einzelnen Signalabschnitt soweit verstellt, bis gewährleistet ist, dass in jedem einzelnen Signalabschnitt der einzelnen binären Signale nicht mehr als eine Signalflanke auftritt.

In einer zweiten Ausführungsform werden von einem Detektor kontinuierlich über jeweils aufeinander folgende Zeiträume die Pulsdauern sämtlicher Pulse und die Dauern von Pulspausen zwischen aufeinander folgenden Pulsen in allen binären Signalen gemessen und die jeweils minimale Pulsdauer bzw. minimale Pulspause ermittelt. Anschließend wird kontinuierlich von einer Steuerungseinheit der Dezimationsfaktor soweit verändert, bis der Dezimationsfaktor kleiner oder gleich der für die minimale Dauer ermittelten Anzahl von Abtastwerten ist.

Das Verfahren und die Vorrichtung zum Kennzeichnen einer durch Dezimierung entfernten Signalflanke, das erfindungsgemäße Verfahren und die erfindungsgemäße Vorrichtung zur Anpassung des Dezimationsfaktors in Abhängigkeit der Anzahl von Signalflanken pro Anzahl von Abtastwerten und das erfindungsgemäße Verfahren und die erfindungsgemäße Vorrichtung zur Anpassung eines Dezimationsfaktors in Abhängigkeit der Dauer von Pulsen und/oder Pulspausen werden im folgenden im Detail anhand der Zeichnung erläutert. Die Figuren der Zeichnung zeigen:
- Fig. 1A: ein Zeitdiagramm eines zeitlich am Display zu komprimierenden binären Signals mit Abtastzeitpunkten,
- Fig. 1B: eine Display-Darstellung eines dezimierten binären Signals mit durch Dezimierung entfernten Signalflanken,
- Fig. 2A: ein Zeitdiagramm mit drei zu einem Bussignal gehörigen binären Signalen,
- Fig. 2B: eine Display-Darstellung der Häufigkeiten von Signalpegel und Signalflanken der drei zu einem Bussignal gehörigen binären Signale,
- Fig. 2C: eine Display-Darstellung der Häufigkeiten von Signalpegel und Signalflanken der drei zu einem Bussignal gehörigen und dezimierten binären Signale,
- Fig. 3A: ein Zeitdiagramm mit zwei zu einem Bussignal gehörigen binären Signalen,
- Fig. 3B: zwei Display-Darstellungen der zwei zu einem Bussignal gehörigen binären Signale, die Signalflanken enthalten,
- Fig. 4: eine Display-Darstellung von vier zu einem Bussignal gehörigen binären Signale mit durch Dezimierung entfernter Signalflanke,
- Fig. 5: ein Flussdiagramm eines Verfahren zum Kennzeichnen einer durch Dezimierung entfernten Signalflanke,
- Fig. 6: ein Flussdiagramm eines erfindungsgemäßen Verfahren zur Anpassung des Dezimationsfaktors in Abhängigkeit der Anzahl von Signalflanken pro Anzahl von Abtastwerten,
- Fig. 7: ein Flussdiagramm eines erfindungsgemäßen Verfahren zur Anpassung eines Dezimationsfaktors in Abhängigkeit der Dauer von Pulsen und/oder Pulspausen,
- Fig. 8: ein Blockdiagramm einer Vorrichtung zum Kennzeichnen einer durch Dezimierung entfernten Signalflanke,
- Fig. 9: ein Blockdiagramm einer erfindungsgemäßen Vorrichtung zur Anpassung des Dezimationsfaktors in Abhängigkeit der Anzahl von Signalflanken pro Anzahl von Abtastwerten und
- Fig. 10: ein Blockdiagramm einer erfindungsgemäßen Vorrichtung zur Anpassung eines Dezimationsfaktors in Abhängigkeit der Dauer von Pulsen und/oder Pulspausen.

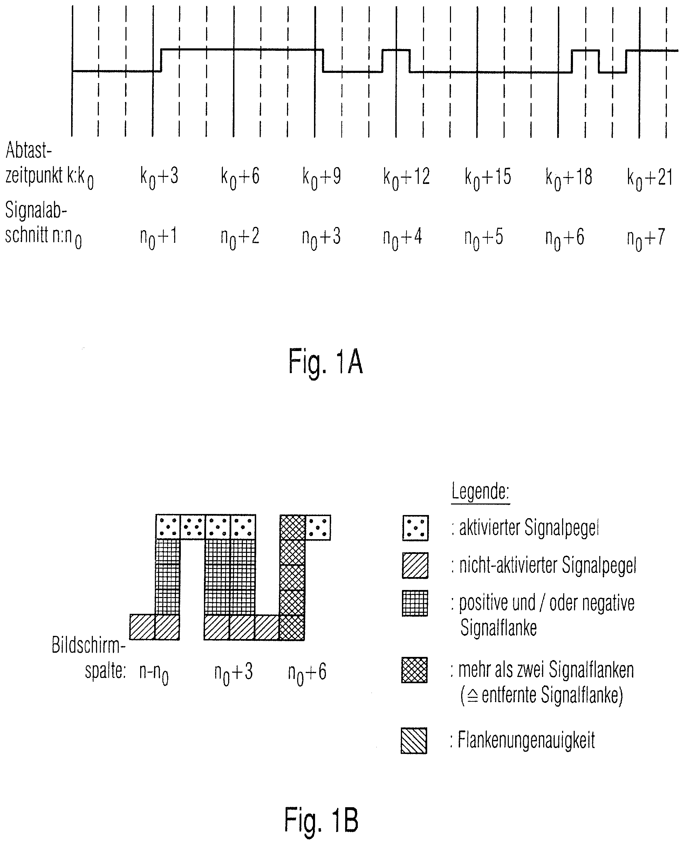

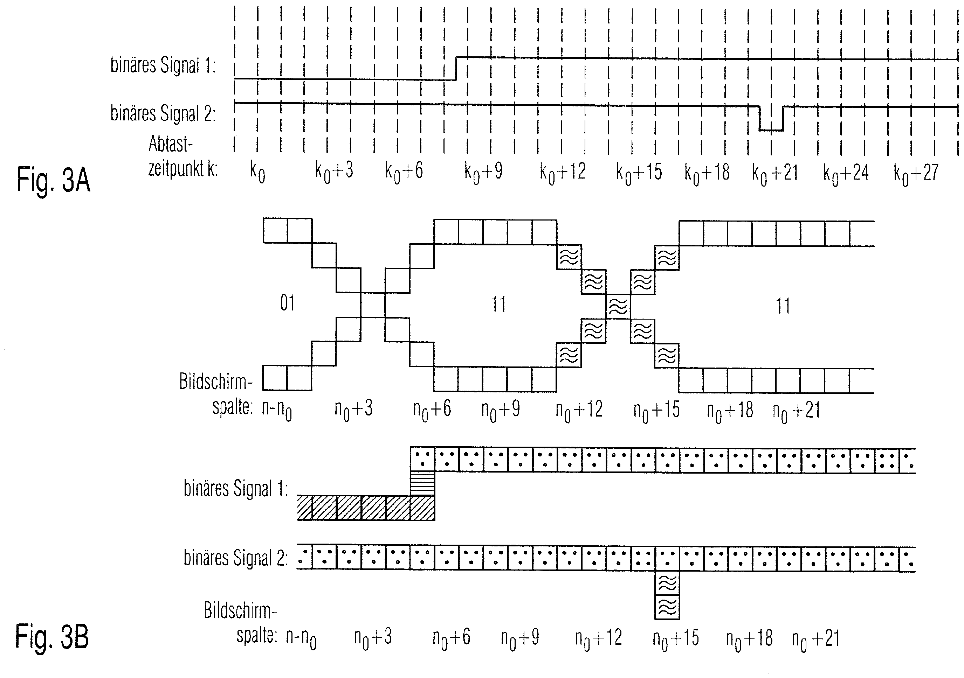

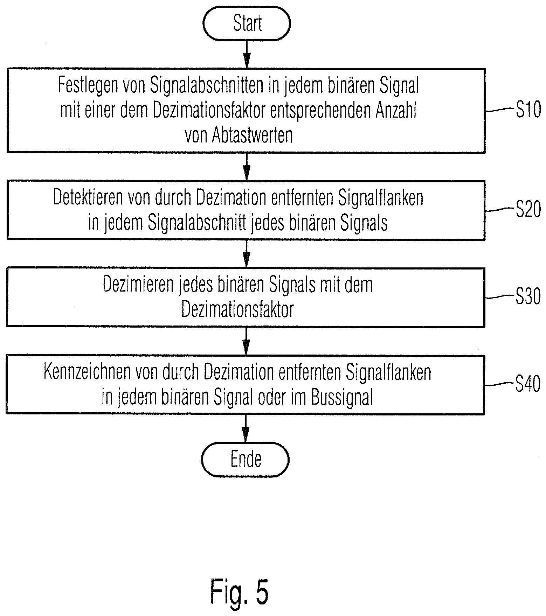

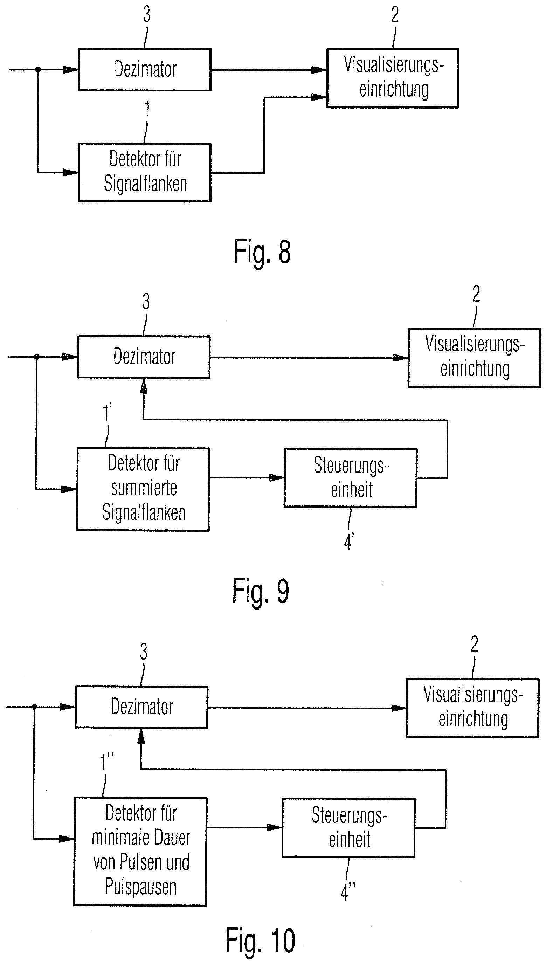

Im Folgenden werden das Verfahren und die Vorrichtung zur Kennzeichnung von durch Dezimierung entfernten Signalflanken anhand des Flussdiagramms in Fig. 5 und des Blockdiagramms in Fig. 8 erläutert:
Im ersten Verfahrensschritt S10 werden für das zu dezimierende binäre Signal bzw. für jedes zu einem Bussignal gehörige und zu dezimierende binäre Signal jeweils aufeinander folgende Signalabschnitte mit einer festen Anzahl von Abtastwerten festgelegt, die dem Dezimationsfaktor der Dezimierung entspricht. In den Figuren 1A und 3A entspricht ein Signalabschnitt jeweils ein durch jeweils zwei durchgezogene Linien begrenzter Bereich von drei Abtastwerten.

Im nächsten Verfahrensschritt S20 wird in jedem im vorherigen Verfahrensschritt S10 festgelegten Signalabschnitt des zu dezimierenden binären Signals bzw. der zu einem Bussignal jeweils gehörigen und zu dezimierenden binären Signale jeweils jede Signalflanke in einem Detektor 1 für Signalflanken detektiert, die durch eine im anschließenden Verfahrensschritt S30 durchzuführende Dezimierung als solche im zugehörigen dezimierten binären Signal nicht eindeutig erkennbar ist und somit als durch die Dezimierung entfernte Signalflanke gilt.

Eine einzige Signalflanke innerhalb eines Signalabschnitts eines binären Signals kann nach der Dezimierung - auch hinsichtlich ihrer Signalflankenrichtung - eindeutig identifiziert werden, wenn die jeweils vorherigen und/oder die jeweils nachfolgenden Signalabschnitte jeweils nur eine Signalflanke enthalten und von jeweils einem Signalabschnitt mit keiner Signalflanke umrahmt sind. Beispielsweise stellt die Signalflanke im Abtastzeitpunkt k₀+3 der Fig. 1A die einzige Signalflanke im zweiten Signalabschnitt n₀+1 des binären Signals dar. Da die Signalpegel in allen Abtastzeitpunkten des vorherigen Signalabschnitts n₀ nicht-aktiviert sind und gleichzeitig die Signalpegel in allen Abtastzeitpunkten des nachfolgenden Signalabschnitts n₀+2 aktiviert sind, ist eindeutig aus der Display-Darstellung des zugehörigen dezimierten binären Signals in Fig. 1B eine Signalflanke mit einer positiven Flankenrichtung entnehmbar. Auch die einzige Signalflanke des fünften Signalabschnitts n₀+4 im Abtastzeitpunkt k₀+12 kann eindeutig in der Display-Darstellung der Fig. 1B als fallende Flanke identifiziert werden, da alle Abtastwerte des nachfolgenden sechsten Signalabschnitts n₀+5 des binären Signals nicht-aktiviert sind.

Liegen dagegen zwei Signalflanken pro Signalabschnitt vor, so können diese beiden Signalflanken mit ihren korrekten Signalflankenrichtungen aus dem Signalpegelverlauf des dezimierten binären Signals nicht eindeutig ermittelt werden. Die beiden Signalflanken - fallende und steigende Signalflanke - im vierten Signalabschnitt n₀+3 des binären Signals in Fig. 1A können mit ihrer korrekten Signalflankenrichtung nicht eindeutig aus dem zugehörigen dezimierten binären Signal in Fig. 1B identifiziert werden, da in dem nachfolgenden fünften Signalabschnitt n₀+4 eine einzige Signalflanke -eine fallende Signalflanke - vorliegt. Diese Kombination kann nicht eindeutig von der Kombination unterschieden werden, bei der im vierten Signalabschnitt n₀+3 eine einzige Signalflanke - eine fallende Signalflanke - vorliegt und gleichzeitig im fünften Signalabschnitt n₀+4 zwei Signalflanken - eine steigende Flanke und eine fallende Signalflanke - vorliegen..

Auch eine Anzahl von drei, vier oder mehr Signalflanken im Signalabschnitt des dezimierten binären Signals kann nicht eindeutig vom Fall des Vorliegens von einer Signalflanke pro Signalabschnitt im binären Signal unterschieden werden. Somit können zwei oder mehr Signalflanken pro Signalabschnitt im dezimierten binären Signal nicht eindeutig als solche identifiziert werden. Die drei Signalflanken im siebten Signalabschnitt n₀+6 können nicht eindeutig identifiziert werden, da aus der Analyse des Signalpegels des dezimierten binären Signals in den benachbarten Signalabschnitten n₀+5 und n₀+7 auch auf einen Signalabschnitt mit einer einzigen Signalflanke geschlossen werden kann.

Im nächsten Verfahrensschritt S30 werden das binäre Signal bzw. die zum Bussignal gehörigen binären Signale in einem Dezimator 3 mit dem fixen und für alle binären Signale identischen Dezimationsfaktor dezimiert.

Schließlich erfolgt im abschließenden Verfahrensschritt S40 die Darstellung des dezimierten binären Signals bzw. der dezimierten, zum Bussignal gehörigen binären Signale und die Kennzeichnung der durch Dezimierung entfernten Signalflanken auf einem Display der Visualisierungseinrichtung 2.

Für den Fall der Dezimierung eines einzigen binären Signals werden die Abtastwerte des zugehörigen dezimierten binären Signals gemäß Fig. 1B jeweils als Bildpunkte auf dem Display der Visualisierungseinrichtung 2 dargestellt, wobei die Wertigkeit des Signalpegels des jeweiligen Abtastwerts den Ordinatenwert und der zugehörige Abtastzeitpunkt den Abszissenwert eines Ordinaten-Abszissen-Wertepaares erhält, das zum Ordinaten-Abszissen-Wertepaar des zugehörigen Bildpunktes korrespondiert. Signalflanken werden durch Bildpunkte auf einer vertikalen Geraden zwischen einem Bildpunkt, dessen Ordinatenwert einen aktivierten Signalpegel eines Abtastwerts des dezimierten binären Signals darstellt, und einem Bildpunkt dargestellt, dessen Ordinatenwert einen nicht-aktivierten Signalpegel eines Abtastwerts des dezimierten binären Signals darstellt. Durch Dezimierung entfernte Signalflanken im dezimierten binären Signal werden durch Bildpunkte in einem gesonderten Farb- oder Grauton gekennzeichnet. Zur Darstellung kann jeder auf der Geraden liegende Bildpunkt oder auch nur jeder n-te auf der Geraden liegende Bildpunkt herangezogen werden. Alternativ können auch alle Bildpunkte der Bildschirmspalte, in der die entfernte Signalflanke liegt, gekennzeichnet werden.

Für den Fall der Dezimierung von mehreren, zu jeweils einem Bussignal gehörigen binären Signalen wird die Häufigkeit der beim einzelnen Abtastzeitpunkt jeweils auftretenden Wertigkeit des Signalpegels, d.h. aktivierter oder nicht-aktivierter Signalpegel, oder die Häufigkeit der beim einzelnen Abtastzeitpunkt jeweils auftretenden Signalflanke über alle binären Signale des Bussignals gezählt und als entsprechender Farb- oder Grauton des Bildpunkts dargestellt. Das Ordinaten-Abszissen-Wertepaar des jeweiligen Bildpunkts korrespondiert zum Ordinatenwert, der eine Wertigkeit des Signalpegels der einzelnen binären Signale zu einem Abtastzeitpunkt darstellt, und zum Abszissenwert, der den Abtastzeitpunkt darstellt.

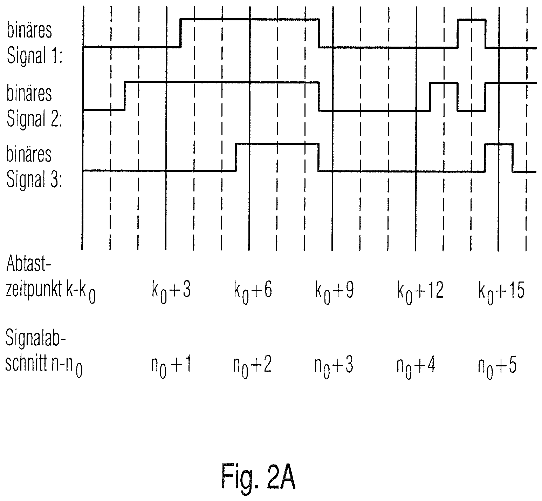

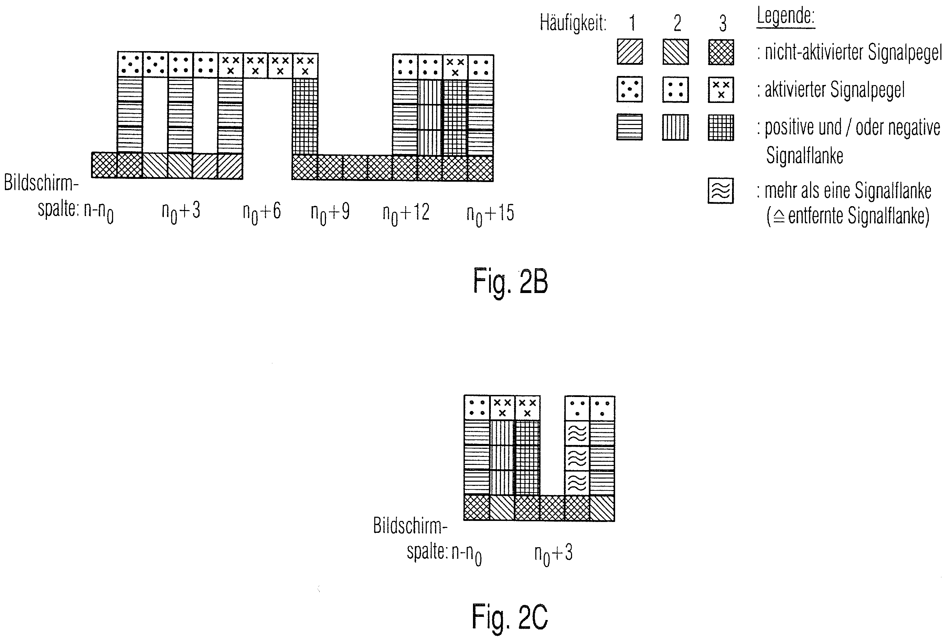

Für den Fall, dass gemäß Fig. 2A weder eine zeitliche Komprimierung noch eine zeitliche Dehnung der einzelnen zum Bussignal gehörigen binären Signale durchgeführt wird, ist eine Display-Darstellung der Häufigkeiten der bei den einzelnen Abtastzeitpunkten jeweils auftretenden Wertigkeiten des Signalpegels oder der Häufigkeit der bei den einzelnen Abtastzeitpunkten jeweils auftretenden Signalflanken über alle binären Signale des Bussignals in Fig. 2B dargestellt. Eine erste Variante einer Display-Darstellung für mehrere zu einem Bussignal gehörige und dezimierte binäre Signale ist für den Fall einer Dezimierung um den Dezimationsfaktor drei, in der die Häufigkeiten der bei den einzelnen Abtastzeitpunkten jeweils auftretenden Wertigkeiten des Signalpegels oder die Häufigkeiten der bei den einzelnen Abtastzeitpunkten jeweils auftretenden Signalflanken über alle binären Signale des Bussignals dargestellt sind, Fig. 2C zu entnehmen. In Fig. 2C erkennt man in der Bildschirmspalte n₀+4 die durch Dezimierung aus den Signalabschnitt n₀+4 entfernten und gekennzeichneten Signalflanken, nämlich die dreifach im binären Signal 2 auftretenden Signalflanken.

Zwei Display-Darstellungen für mehrere zu einem Bussignal gehörige binäre Signale ist Fig. 3B zu entnehmen. Hierbei wird eine zeitliche Komprimierung/Dezimierung der binären Signale um den Faktor zwei durchgeführt. In Analogie zur Darstellung in Fig. 1B für ein einziges dezimiertes binäres Signal ist in Fig. 3B unten eine zweite Variante einer Display-Darstellung dargestellt, bei der für die beiden binären Signale aus Fig. 3A jeweils eine getrennte Darstellung vorgesehen ist. Zu erkennen ist die im Abtastzeitpunkt k₀+14 auftretende und in der zugehörigen Bildschirmspalte n₀+14 dargestellte entfernte Signalflanke.

Neben der Display-Darstellung in Fig. 3B unten, die für die beiden binären Signale jeweils eine getrennte Darstellung repräsentiert, ist in Fig. 3B oben eine dritte Variante einer Display-Darstellung vorgesehen, in der beide binären Signale zu einem binären Signal kombiniert werden. Hierbei wird die Wertigkeit der Signalpegel der beiden binären Signale zu den einzelnen Abtastzeitpunkten neutralisiert durch einen eine aktivierte Wertigkeit des Signalpegels darstellenden Bildpunkt und gleichzeitig durch einen eine nicht-aktivierte Wertigkeit des Signalpegels darstellenden Bildpunkt zu den einzelnen Abtastzeitpunkten dargestellt. Die Wertigkeiten der Signalpegel der einzelnen binären Signale des Bussignals werden in einem einzigen Binär-, Oktal- oder Hexadezimalwert zusammengefasst, dessen Ziffern zu den einzelnen Abtastzeitpunkten zwischen dem eine aktivierte Wertigkeit des Signalpegels und dem eine negative Wertigkeit des Signalpegels darstellenden Bildpunkten platziert werden.

Einzig eine in einem binären Signal oder in mehreren binären Signalen in einem Abtastzeitpunkt jeweils auftretende Signalflanke wird durch Bildpunkte in einer Bildschirmspalte, die zum Signalabschnitt der binären korrespondiert, und in jeweils links- und rechtsseitig benachbarten Bildschirmspalten dargestellt, die in Kombination jeweils eine Signalflanke mit einer positiven Signalflankenrichtung und eine Signalflanke mit einer negativen Signalflankenrichtung bilden. Liegt eine entfernte Signalflanke vor, so werden die eine Signalflanke mit einer positiven Signalflankenrichtung und gleichzeitig eine Signalflanke mit einer negativen Signalflankenrichtung bildenden Bildpunkte in einem gesonderten Farb- oder Grauton dargestellt.

In einer vierten Variante einer Display-Darstellung für mehrere zu einem Bussignal gehörige binäre Signale werden die einzelnen Wertigkeiten der Signalpegel der zum Bussignal gehörigen binären Signale in den einzelnen Abtastzeitpunkten ebenfalls in einem Binär-, Oktal- oder Hexadezimalwert zusammengefasst und ergeben den Ordinatenwert eines Ordinaten-Abszissenwertepaares, dessen Abszissenwert der zugehörige Abtastzeitpunkt bildet. Dieses Ordinaten-Abszissen-Wertepaar wird durch einen Bildpunkt mit einem korrespondierenden Ordinaten-Abszissen-Wertepaar in einem bestimmten Farb- oder Grauton dargestellt. Jeweils auf diese Weise auf dem Display der Visualisierungseinheit 2 dargestellte und zeitlich aufeinander folgende und damit horizontal benachbarte Bildpunkte werden durch Bildpunkte mit identischem Grau- oder Farbton auf einer vertikalen Gerade verbunden, deren Ordinatenwerte zwischen den Ordinatenwerten der jeweils zeitlich benachbarten Bildpunkte liegen und deren Abszissenwert dem jeweils höheren Abszissenwert der jeweils zeitlich benachbarten Bildpunkte entspricht.

Treten durch Dezimierung entfernte Signalflanken in einem oder mehreren der zum Bussignal gehörigen dezimierten binären Signale auf, so werden diese entfernten Signalflanken durch Bildpunkte auf einer vertikalen Gerade in einem gesonderten Farb- oder Grauton dargestellt. Der Abszissenwert der auf der vertikalen Gerade liegenden Bildpunkte, die eine oder mehrere entfernte Signalflanken darstellen, entspricht dem Abszissenwert des Abtastzeitpunkts der dezimierten binären Signale, in denen durch Dezimierung entfernte Signalflanken vorliegen. Die Ordinatenwerte der auf der vertikalen Gerade liegenden Bildpunkte, die eine oder mehrere entfernte Signalflanken darstellen, liegen zwischen zwei Grenzwerten des Wertebereichs des Binär-, Oktal- oder Hexadezimal-Werts, der aus der nicht eindeutigen Zuordnung eines Signalpegels in einem oder mehreren der binären Signale zu einem Wert im Fall von einer bzw. mehrerer Signalflanken in einem bzw. mehreren binären Signalen des Bussignals resultiert.

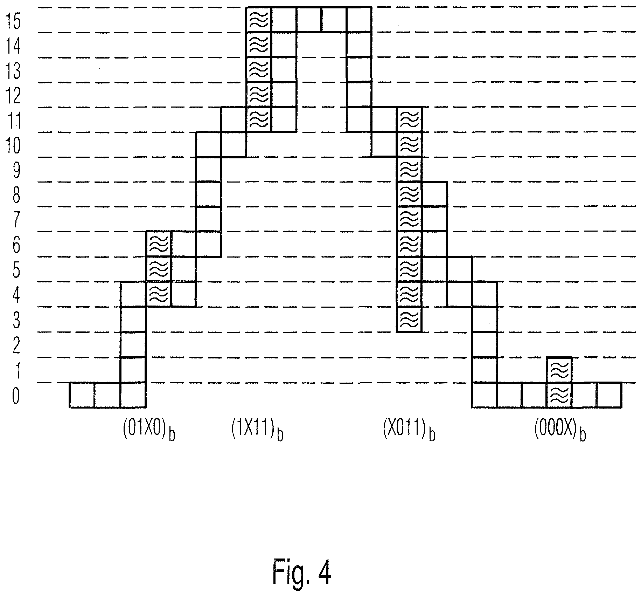

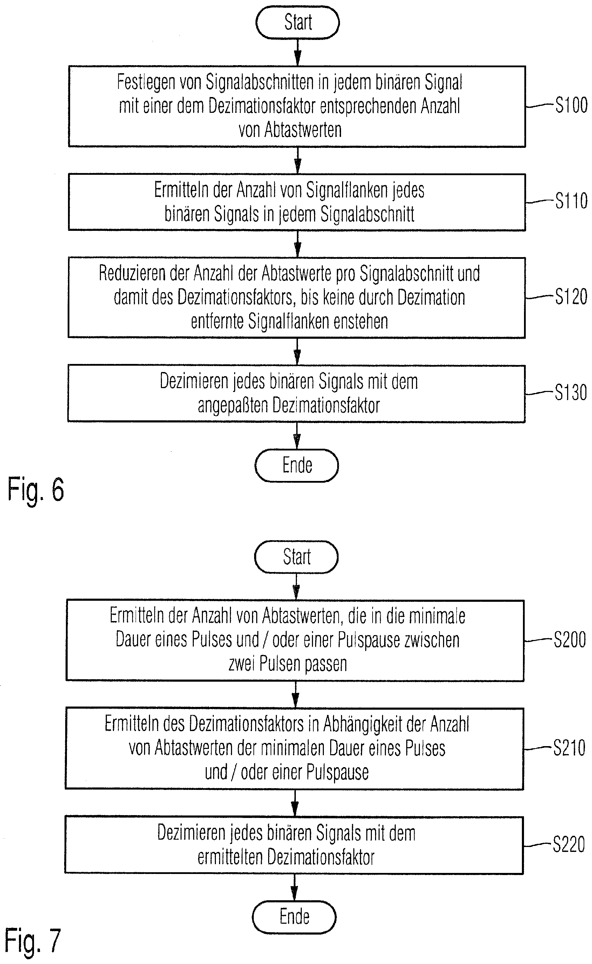

In einer fünften Variante einer Display-Darstellung gemäß Fig. 4 für mehrere zu einem Bussignal gehörige binäre Signale werden die Wertigkeiten der Signalpegel der einzelnen zu einem Bussignal gehörigen binären Signale zu den einzelnen Abtastzeitpunkten als Binär-, Oktal- und Hexadezimalwert zusammengefasst und als zugehörige Ziffern dargestellt. Die Binär-, Oktal- oder Hexadezimalziffer des jeweiligen Binär-, Oktal- und Hexadezimalwerts, die sich auf ein binäres Signal bezieht, in der zum jeweiligen Abtastzeitpunkt durch Dezimierung eine Signalflanke entfernt ist, wird durch eine Sonderziffer, beispielsweise ein X, dargestellt und wird optional durch farbliches Hervorheben der Sonderziffer mit einer besonderen Farbe zusätzlich gekennzeichnet. Äquivalent zur Displaydarstellung mehrerer zu einem Bussignal gehöriger binärer Signale können auch mehrere sequentiell aufeinander folgende Signalabschnitte eines einzigen binären Signals zusammengefasst werden. Im Folgenden wird das erfindungsgemäße Verfahren zur Anpassung des Dezimationsfaktors in Abhängigkeit der Anzahl von Signalflanken pro Anzahl von Abtastwerten anhand des Flussdiagramms in Fig. 6 und die zugehörige Vorrichtung zur Anpassung des Dezimationsfaktors in Abhängigkeit der Anzahl von Signalflanken pro Anzahl von Abtastwerten anhand des Blockdiagramms in Fig. 9 beschrieben.

Im ersten Verfahrensschritt S100 werden für das zu dezimierende binäre Signal bzw. für jedes zu einem Bussignal gehörige und zu dezimierende binäre Signal jeweils aufeinander folgende Signalabschnitte mit einer festen Anzahl von Abtastwerten festgelegt, die dem Dezimationsfaktor der Dezimierung entspricht.

Im nächsten Verfahrensschritt S110 wird in jedem im vorherigen Verfahrensschritt S100 festgelegten Signalabschnitt des zu dezimierenden binären Signals bzw. der zu einem Bussignal jeweils gehörigen und zu dezimierenden binären Signale jeweils jede Signalflanke in einem Detektor 1' für summierte Signalflanken detektiert und durch Summation der detektierten Signalflanken die Anzahl der Signalflanken pro Signalabschnitt in jedem einzelnen binären Signal bzw. in jedem binären Signal des Bussignals ermittelt.

Im darauffolgenden Verfahrensschritt S120 wird die Anzahl von Abtastwerten pro Signalabschnitt im einzelnen binären Signal oder in jedem zum Bussignal gehörigen binären Signal und damit der Dezimationsfaktor der Dezimierung in einer Steuerungseinheit 4' reduziert, bis in jedem Signalabschnitt maximal eine Signalflanke auftritt und somit durch die Dezimierung keine Signalflanken verloren geht.

Im abschließenden Verfahrensschritt S130 wird das einzelne binäre Signal oder die zum Bussignal gehörigen binären Signale durch den Dezimator 3 mit dem reduzierten bzw. angepassten Dezimationsfaktor zu einem einzelnen dezimierten binären Signal oder zu dezimierten zum Bussignal gehörigen binären Signalen dezimiert. Das dezimierte binäre Signal bzw. die dezimierten, zu einem Bussignal jeweils gehörigen binären Signale werden schließlich auf dem Display einer Visualisierungseinrichtung 2 dargestellt.

Im Folgenden wird das erfindungsgemäße Verfahren zur Anpassung eines Dezimationsfaktors in Abhängigkeit der Dauer von Pulsen und/oder Pulspausen anhand des Flussdiagramms in Fig. 7 und die zugehörige Vorrichtung zur Anpassung eines Dezimationsfaktors in Abhängigkeit der Dauer von Pulsen und/oder Pulspausen anhand des Blockdiagramms in Fig. 10 beschrieben.

Im ersten Verfahrensschritt S200 wird für das einzelne binäre Signal bzw. für alle zu einem Bussignal gehörigen und zu dezimierenden binären Signale in einem Detektor 1" für minimale Dauer von Pulsen und Pulspausen die Anzahl von Abtastwerten ermittelt, die in die vom Detektor 1" ermittelte minimale Dauer aller in einem bestimmten Zeitraum vom Detektor 1" im einzelnen binären Signal oder in allen zum Bussignal gehörigen binären Signalen detektierten Pulse oder detektierten Pulspausen zwischen zwei aufeinander folgenden Pulsen fallen.

Im nächsten Verfahrensschritt S210 wird von einer Steuerungseinheit 4" der Dezimationsfaktor der Dezimierung in Abhängigkeit der im vorherigen Verfahrensschritt S200 ermittelten Anzahl von Abtastwerten, die in die minimale Dauer aller in einem Zeitraum detektierten Pulse und Pulspausen fallen, ermittelt, indem der Dezimationsfaktor kleiner oder gleich der Anzahl von Abtastwerten eingestellt wird, die in die minimale Dauer aller in einem Zeitraum detektierten Pulse und Pulspausen fallen.

Im abschließenden Verfahrensschritt S220 wird das einzelne binäre Signal oder die zum Bussignal gehörigen binären Signale durch den Dezimator 3 mit dem reduzierten bzw. angepassten Dezimationsfaktor zu einem einzelnen dezimierten binären Signal oder zu dezimierten zum Bussignal gehörigen binären Signalen dezimiert. Das dezimierte binäre Signal bzw. die dezimierten, zu einem Bussignal jeweils gehörigen binären Signale werden schließlich auf dem Display einer Visualisierungseinrichtung 2 dargestellt. Das erfindungsgemäße Verfahren und die erfindungsgemäße Vorrichtung zum Verhindern von Signalflankenverlusten durch Dezimierung von binären Signalen sind nicht auf die einzelnen dargestellten Ausführungsformen und Varianten beschränkt. Neben der gesonderten Farb- oder Grautönung von Bildpunkten sind auch andere Kennzeichnungen der durch Dezimierung entfernten Signalflanken in dezimierten binären Signalen wie beispielsweise Blinken von Bildpunkten oder andere Leuchtstärke der Bildpunkte oder Kennzeichnung mittels Pfeilen möglich.

## Patentansprüche

1. Verfahren zur Anpassung eines Dezimationsfaktors einer Dezimierung von mindestens einem binären Signal in Abhängigkeit der Anzahl von Signalflanken pro Anzahl von Abtastwerten in den einzelnen binären Signalen mit folgenden Verfahrensschritten:
• Festlegen von jeweils aufeinander folgenden Signalabschnitten der einzelnen binären Signale mit einer dem Dezimationsfaktor der Dezimierung entsprechenden Anzahl von Abtastwerten,
• Ermitteln der Anzahl von Signalflanken der einzelnen binären Signale innerhalb jedes einzelnen Signalabschnitts,
• Reduzierung der Anzahl von Abtastwerten in jedem Signalabschnitt und damit des Dezimationsfaktors, bis in jedem Signalabschnitt jeweils bis zu einer Signalflanke der einzelnen binären Signale auftreten und
• Ermitteln von Abtastwerten von mindestens einem dezimierten binärem Signal durch Dezimierung der Abtastwerte des zugehörigen binären Signals mit dem angepassten Dezimationsfaktor.

2. Verfahren zur Anpassung eines Dezimationsfaktors einer Dezimierung von mindestens einem binären Signal in Abhängigkeit der Dauer von in den einzelnen binären Signalen enthaltenen Pulsen und/oder Pulspausen mit folgenden Verfahrensschritten:
• Ermitteln der Anzahl von Abtastwerten, die in die minimale Dauer von in den einzelnen binären Signalen jeweils enthaltenen Pulsen und/oder Pulspausen fallen,
• Ermitteln des Dezimationsfaktors, der kleiner oder gleich der für die minimale Dauer ermittelten Anzahl von Abtastwerten ist, und
• Ermitteln von Abtastwerten von mindestens einem dezimierten binärem Signal durch Dezimierung der Abtastwerte des zugehörigen binären Signals mit dem angepassten Dezimationsfaktor.

3. Vorrichtung zur Anpassung eines Dezimationsfaktors einer Dezimierung von mindestens einem binären Signal in Abhängigkeit der Anzahl von Signalflanken pro Anzahl von Abtastwerten in den einzelnen binären Signalen mit
einem Dezimator (3) zur Erzeugung von mindestens einem dezimierten binären Signal mittels Dezimierung des zugehörigen binären Signals mit einem Dezimationsfaktor,
einem Detektor (1') zur Detektion von Signalflanken in den einzelnen binären Signalen und
einer Steuerungseinheit (4'), die derart ausgebildet ist, um für das mindestens eine binäre Signal jeweils aufeinander folgende Signalabschnitte mit einer dem Dezimationsfaktor entsprechenden Anzahl von Abtastwerten festzulegen und die Anzahl von Abtastwerten pro Signalabschnitt in jedem binären Signal und damit den Dezimationsfaktor soweit zu reduzieren, bis in jedem Signalabschnitt maximal eine Signalflanke auftritt.

4. Vorrichtung zur Anpassung eines Dezimationsfaktors einer Dezimierung von mindestens einem binären Signal in Abhängigkeit der Dauer von in den einzelnen binären Signalen enthaltenen Pulsen und/oder Pulspausen mit
einem Dezimator (3) zur Erzeugung von mindestens einem dezimierten binären Signal mittels Dezimierung des zugehörigen binären Signals mit einem Dezimationsfaktor,
einem Detektor (1") zur Ermittlung der minimalen Dauer der in den einzelnen binären Signalen enthaltenen Pulse und/oder Pulspausen und
einer Steuerungseinheit (4"), die derart ausgebildet ist, um den Dezimationsfaktor kleiner oder gleich der Anzahl von Abtastwerten einzustellen, die in die minimale Dauer aller in einem Zeitraum in dem mindestens einen binären Signal jeweils detektierten Pulse und Pulspausen fallen.

5. Computerprogramm mit Programmcode-Mitteln, um alle Schritte gemäß Anspruch 1 oder 2 durchführen zu können, wenn das Programm auf einem Computer oder einem digitalen Signalprozessor ausgeführt wird.

6. Maschinenlesbarer Träger mit darauf gespeicherten Programmcode-Mitteln, um alle Schritte gemäß Anspruch 1 oder 2 durchführen zu können, wenn das Programm auf einem Computer oder einem digitalen Signalprozessor ausgeführt wird.

## Claims

1. Method for adjusting a decimation factor for decimation of at least one binary signal as a function of the number of signal edges per number of sampled values in the individual binary signals with the following method steps:
- definition of successive signal sections of the individual binary signals with a number of sampled values corresponding to the decimation factor for the decimation,
- determination of the number of signal edges of the individual binary signals within each individual signal section,
- reduction of the number of sampled values in each signal section and hence of the decimation factor until a maximum of one signal edge of the individual binary signals appears in each signal section and
- determination of sampled values of at least one decimated binary signal by decimation of the sampled values of the associated binary signal with the adjusted decimation factor.

2. Method for adjusting a decimation factor for decimation of at least one binary signal as a function of the length of pulses and/or intervals between pulses contained in the individual binary signals with the following method steps:
- determination of the number of sampled values which fall in the minimum length of pulses and/or intervals between pulses contained in the individual binary signals in each case,
- determination of the decimation factor which is less than or equal to the number of sampled values determined for the minimum length, and
- determination of sampled values of at least one decimated binary signal by decimation of the sampled values of the associated binary signal with the adjusted decimation factor.

3. Device for adjusting a decimation factor for decimation of at least one binary signal as a function of the number of signal edges per number of sampled values in the individual binary signals with
- a decimator (3) for generation of at least one decimated binary signal by means of decimation of the associated binary signal with a decimation factor,
- a detector (1') for detection of signal edges in the individual binary signals and
- a control unit (4') which is configured to define successive signal sections with a number of sampled values corresponding to the decimation factor for the at least one binary signal and to reduce the number of sampled values per signal section in each binary signal and hence the decimation factor until a maximum of one signal edge appears in each signal section.

4. Device for adjusting a decimation factor for decimation of at least one binary signal as a function of the length of pulses and/or intervals between pulses contained in the individual binary signals with
- a decimator (3) for generation of at least one decimated binary signal by means of decimation of the associated binary signal with a decimation factor,
- a detector (1") for determining the minimum length of the pulses and/or intervals between pulses contained in the individual binary signals and
- a control unit (4") which is configured to make the decimation factor less than or equal to the number of sampled values which fall in the minimum length of all the pulses and intervals between pulses detected in a period of time in the at least one binary signal in each case.

5. Computer programme with programme code means in order to be able to carry out all the steps according to claim 1 or 2 when the programme is implemented on a computer or a digital signal processor.

6. Machine-readable data storage medium with programme code means stored on it in order to be able to carry out all the steps according to claim 1 or 2 when the programme is implemented on a computer or a digital signal processor.

## Revendications

1. Procédé d'ajustement d'un facteur de décimation d'une décimation d'au moins un signal binaire en fonction du nombre de flancs de signal par nombre d'échantillons dans les signaux binaires individuels avec les étapes de procédé suivantes :
• établissement de tronçons de signal respectivement consécutifs des signaux binaires individuels avec un nombre d'échantillons correspondant au facteur de décimation de la décimation,
• détermination du nombre de flancs de signal des signaux binaires individuels à l'intérieur de chaque tronçon de signal individuel,
• réduction du nombre d'échantillons dans chaque tronçon de signal et ce faisant du facteur de décimation, jusqu'à ce que dans chaque tronçon de signal apparaisse respectivement jusqu'à un flanc de signal des signaux binaires individuels et
• détermination d'échantillons d'au moins un signal binaire décimé par décimation des échantillons du signal binaire adéquat avec le facteur de décimation ajusté.

2. Procédé d'ajustement d'un facteur de décimation d'une décimation d'au moins un signal binaire en fonction de la durée d'impulsions et/ou d'intervalles d'impulsion contenu(e)s dans les signaux binaires individuels avec les étapes de procédé suivantes :
• détermination du nombre d'échantillons qui tombent dans la durée minimale d'impulsions et/ou d'intervalles d'impulsion respectivement contenu(e)s dans les signaux binaires individuels,
• détermination du facteur de décimation, qui est inférieur ou égal au nombre d'échantillons déterminé pour la durée minimale, et
• détermination d'échantillons d'au moins un signal binaire décimé par décimation des échantillons du signal binaire adéquat avec le facteur de décimation ajusté.

3. Dispositif d'ajustement d'un facteur de décimation d'une décimation d'au moins un signal binaire en fonction du nombre de flancs de signal par nombre d'échantillons dans les signaux binaires individuels avec
un décimateur (3) pour produire au moins un signal binaire décimé au moyen d'une décimation du signal binaire adéquat avec un facteur de décimation,
un détecteur (1') pour détecter des flancs de signal dans les signaux binaires individuels et
une unité de commande (4') qui est ainsi formée pour, pour le au moins un signal binaire, établir des tronçons de signal respectivement consécutifs avec un nombre d'échantillons correspondant au facteur de décimation, et réduire le nombre d'échantillons par tronçon de signal dans chaque signal binaire et ce faisant le facteur de décimation jusqu'à ce que dans chaque tronçon de signal apparaisse au maximum un flanc de signal.

4. Dispositif d'ajustement d'un facteur de décimation d'une décimation d'au moins un signal binaire en fonction de la durée d'impulsions et/ou intervalles d'impulsion contenu(e)s dans les signaux binaires individuels avec
un décimateur (3) pour produire au moins un signal binaire décimé au moyen d'une décimation du signal binaire adéquat avec un facteur de décimation,
un détecteur (1'') pour déterminer la durée minimale des impulsions et/ou intervalles d'impulsion contenu(e)s dans les signaux binaires individuels et
une unité de commande (4'') qui est ainsi formée pour régler le facteur de décimation afin qu'il soit inférieur ou égal au nombre d'échantillons qui tombent dans la durée minimale de tous les impulsions et intervalles d'impulsion respectivement détectés dans un laps de temps dans le au moins un signal binaire.

5. Programme d'ordinateur avec des moyens de code de programme, pour pouvoir réaliser toutes les étapes selon les revendications 1 ou 2, lorsque le programme est exécuté sur un ordinateur ou un processeur de signaux numérique.

6. Support lisible par une machine avec des moyens de code de programme sauvegardés dessus, pour pouvoir réaliser toutes les étapes selon les revendications 1 ou 2, lorsque le programme est exécuté sur un ordinateur ou un processeur de signaux numérique.
